# EUROPEAN PATENT SPECIFICATION

(11) **EP 4 510 135 B1**
(45) Date of publication and mention of the grant of the patent: **02.09.2026**
(21) Application number: 24752853.2
(22) Date of filing: 05.02.2024
(51) Int. Cl.: G11C 29/14, G11C 29/12

(54) **MBIST CONTROL CIRCUIT, METHOD, MEMORY, AND DEVICE**
MBIST-STEUERUNGSSCHALTUNG, VERFAHREN, SPEICHER UND VORRICHTUNG
CIRCUIT DE COMMANDE MBIST, PROCÉDÉ, MÉMOIRE ET DISPOSITIF

(30) Priority: 09.02.2023 CN 202310090777
(43) Date of publication of application: 19.02.2025
(73) Proprietor: CXMT Corporation, Hefei City, Anhui Province 230601 (CN)
(72) Inventor: CHENG, Jingwei, Hefei, Anhui 230601 (CN)
(74) Representative: Gulde & Partner
(86) International application number: PCT/CN2024/075996
(87) International publication number: WO 2024/164998

(56) References cited:
- CN-A- 109 102 838
- CN-A- 114 627 940
- CN-A- 115 985 379
- US-A1- 2010 142 301
- US-A1- 2010 223 513
- US-A1- 2019 198 090
- US-A1- 2020 211 634
- US-A1- 2022 189 573

## Description

### TECHNICAL FIELD

The present disclosure relates to the field of semiconductor technologies, and in particular, to an MBIST control circuit and method, a memory, and a device.

### BACKGROUND

In a development process of semiconductor technologies, because a memory built-in self-test (MBIST) can help resolve serious faults such as single-bit failures or multi-bit failures in a single memory, a problematic memory cell can be found and repaired in an initialization phase in a timely manner. Therefore, the MBIST test has become one of the research directions in the semiconductor technologies.

However, the existing MBIST often takes a long test time, resulting in low test efficiency.

Therefore, how to improve MBIST test efficiency has become a technical problem that needs to be solved urgently.

It should be noted that the information disclosed in the background part is only for enhancing understanding of the background of the present disclosure, and therefore may include information that does not constitute the prior art known to a person of ordinary skill in the art. Background may be found in US2022/189573A1, US 2010/142301A1 and US2010/223513A.

### SUMMARY

Embodiments of the application provides a semiconductor structure, a memory and a method for manufacturing a semiconductor structure.

The invention is set out in the appended set of claims.

The details of one or more embodiments of present application are set forth in the following drawings and description. Other features and advantages of the present application will become apparent from the description, drawings and claims.

### BRIEF DESCRIPTION OF DRAWINGS

The accompanying drawings herein, which are incorporated in and constitute a part of this specification, illustrate embodiments conforming to the present disclosure, and are utilized together with this specification to explain the principles of the present disclosure. Clearly, the accompanying drawings in the following descriptions show merely some embodiments of the present disclosure, and a person of ordinary skill in the art may still derive other drawings from these accompanying drawings without creative efforts.
FIG. 1 shows a system architectural diagram of a storage system according to an embodiment of the present disclosure;
FIG. 2 shows a schematic diagram of a structure of a memory array according to an embodiment of the present disclosure;
FIG. 3 shows a schematic diagram of a structure of an example memory array according to an embodiment of the present disclosure;
FIG. 4 shows a timing control diagram of an MBIST test process;
FIG. 5 shows a timing control diagram of an MBIST test process according to an embodiment of the present disclosure;
FIG. 6 shows a schematic diagram of a structure of an MBIST control circuit according to an embodiment of the present disclosure;
FIG. 7 shows a schematic diagram of a structure of an example MBIST control circuit according to an embodiment of the present disclosure;
FIG. 8 shows a schematic diagram of a structure of another example MBIST control circuit according to an embodiment of the present disclosure;
FIG. 9 shows a schematic logic diagram of signal transmission of an AND gate unit according to an embodiment of the present disclosure;
FIG. 10 shows a schematic logic diagram of a processing logic of a memory control circuit according to an embodiment of the present disclosure;
FIG. 11 shows a schematic logic diagram of generating a negated signal of an MBIST enable signal;
FIG. 12 shows a schematic diagram of a structure of another MBIST control circuit according to an embodiment of the present disclosure;
FIG. 13 shows a schematic diagram of a structure of still another MBIST control circuit according to an embodiment of the present disclosure;
FIG. 14 shows a schematic diagram of a structure of still another example MBIST control circuit according to an embodiment of the present disclosure;
FIG. 15 shows a schematic diagram of a structure of yet another example MBIST control circuit according to an embodiment of the present disclosure;
FIG. 16 shows a schematic logic diagram of signal transmission of an OR gate unit according to an embodiment of the present disclosure; and
FIG. 17 shows a schematic flowchart of an MBIST control method according to an embodiment of the present disclosure.

### DESCRIPTION OF EMBODIMENTS

Now, example implementations are more comprehensively described with reference to the accompanying drawings. However, the example implementations can be implemented in multiple forms and should not be construed as a limitation to the examples described herein. Instead, these implementations are provided to make the present disclosure more comprehensive and complete, and the concept of the example implementations is comprehensively conveyed to a person skilled in the art. The described features, structures, or characteristics may be combined in one or more implementations in any suitable manner.

In addition, the accompanying drawings are merely schematic diagrams of the present disclosure, and are not necessarily drawn in scale. The same reference numbers in the figure represent the same or similar parts, and therefore, repeated descriptions thereof are omitted. Some block diagrams shown in the accompanying drawings are functional entities and may not necessarily correspond to physically or logically independent entities. These functional entities may be implemented in a form of software, or these functional entities are implemented in one or more hardware circuits or integrated circuits, or these functional entities are implemented in different networks and/or processor apparatuses and/or microcontroller apparatuses.

It should be understood that steps recorded in the method implementations of the present disclosure may be performed in different sequences, and/or performed in parallel. In addition, the method implementations may include additional steps and/or omitting shown steps. The scope of the present disclosure is not limited in this respect.

It should be noted that the concepts such as "first" and "second" mentioned in the present disclosure are merely configured to distinguish between different apparatuses, circuits, or units, and are not configured to limit a sequence or an interdependence of functions performed by these apparatuses, circuits, or units.

It should be noted that the modifications "one" and "multiple" mentioned in the present disclosure are examples and constitute no limitation, and a person skilled in the art should understand that, unless otherwise specified in the context, the modifications "one" and "multiple" should be understood as "one or more".

In the field of semiconductor technologies, to ensure normal use of a memory, an operating system in an electronic device needs to perform memory built-in self-test on the memory, so as to identify a possible fault that may exist in the memory when the memory is delivered from a factory. In addition, it is also necessary to detect a memory fault in a timely manner when the operating system is running. Therefore, the MBIST is very important for normal operation of the memory and the operating system.

Before the technical solutions provided in the embodiments of the present disclosure start to be described, a storage system involved in the embodiments of the present disclosure is first described.

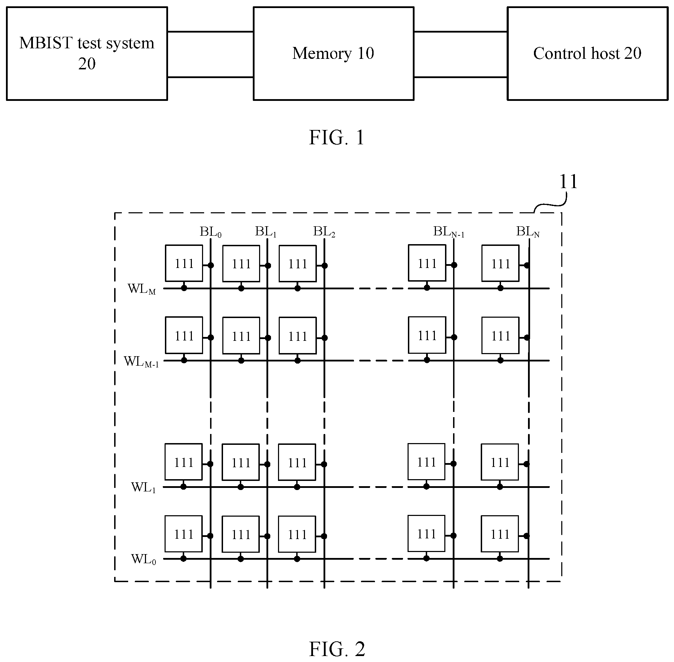

FIG. 1 is a system architectural diagram of a storage system according to an embodiment of the present disclosure. As shown in FIG. 1, the storage system may include an MBIST test system 10, a memory 20, and a control host 30.

The MBIST test system 10 may perform an MBIST test on the memory 20. For example, in an MBIST test process, the MBIST test system 10 may deliver a control command such as a first precharge command to the memory, so as to test a problem in a manner of performing progressive scanning on a word line of a memory array of the memory.

The memory 20 may send a signal to the control host when an active command count of a word line reaches a preset quantity threshold. The memory may include multiple memory arrays. For example, FIG. 2 shows a schematic diagram of a structure of a memory array according to an embodiment of the present disclosure. As shown in FIG. 2, the memory array 11 includes multiple memory cells 111, multiple word lines WL₀ to WL_{M}, and multiple bit lines BL₀ to BL_{N}. Both M and N are any positive integers. Memory cells in a same row are connected on a same word line.

The control host 30 may send an RFM command to the memory 20 for refreshing in response to the signal sent by the memory 20.

After the storage system in the embodiments of the present disclosure is described, the following continues to describe the technical terms in the embodiments of the present disclosure.

### (1) Row hammer effect

When a single start time period of a single-row address in a memory cell is too long, a discharge rate of a capacitor of a neighboring address (generally referred to as a "hammer address") may be caused to be higher than a natural discharge rate, thereby causing the capacitor of the neighboring address to lose data due to excessive charge loss before a refresh signal arrives. This case is generally referred to as a "row hammer effect".

To suppress the row hammer effect, a timely refresh operation needs to be performed on the row hammer address to replenish the charge and avoid an error in storing data.

(2) Per row hammer tracking (PRHT), that is, an operation for mitigating the row hammer effect for ease of description, per row hammer tracking in the following description of the specification is briefly described as PRHT.

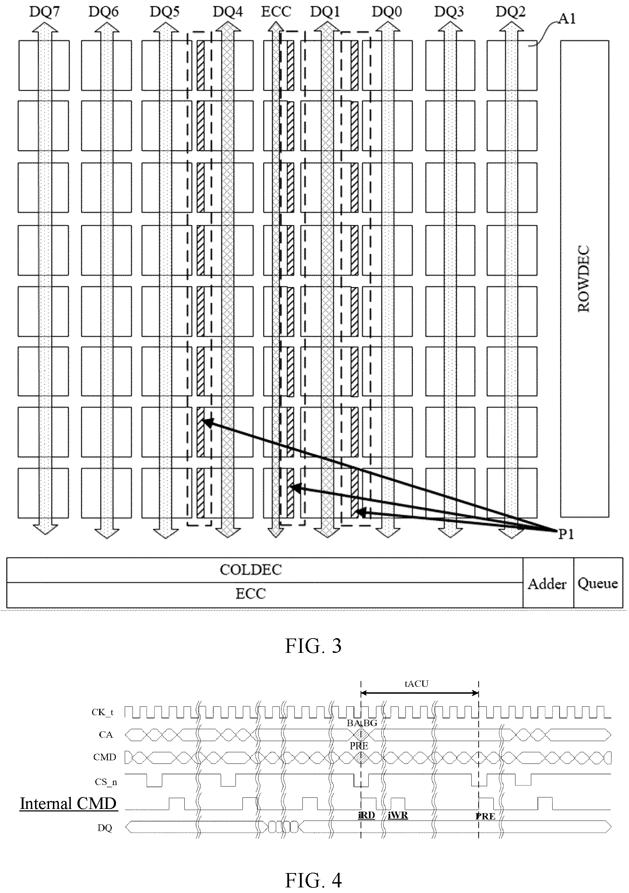

Specifically, FIG. 3 shows a schematic diagram of a structure of an example memory array according to an embodiment of the present disclosure. As shown in FIG. 3, an active command count of a row is counted by adding 16 columns to each row. Specifically, 16 columns may be located at a location P1 shown in a pattern-filled block of a storage subarray.

When an active command count of a row exceeds a specified threshold, an ALERT_n pin is pulled down to notify the control host. The control host sends an RFM command to mitigate the row hammer effect.

(3) RFM command, that is, a command used to control a memory to perform refresh management (RFM) RFM, Auto refresh, and Self refresh are three refresh manners of a memory such as DDR5.

Specifically, after receiving the RFM command, the memory may correspondingly generate an active (ACT) command, a precharge (PRE) command, or the like to implement a refresh operation. Optionally, an active command count of a word line may be reset to zero while the RFM command is being executed.

After the foregoing technical terms are described, the following continues to describe the solutions provided in the embodiments of the present disclosure.

For the problem of low test efficiency of the existing MBIST test, the inventor finds, through research, that in an MBIST test process, sending of active commands and precharge commands are involved. Specifically, each time a command is activated, the memory needs to increase the active command count by 1, and then write the active command count to a row counter unit (Row Counter Cell) of the memory.

Specifically, FIG. 4 shows a timing control diagram of an MBIST test process. As shown in FIG. 4, an active (ACT) command and a precharge (PRE) command appear in pairs. To reduce a latency, a memory such as a DRAM updates a row counter unit (counter cell) only after a PRE command of a CMD bus is received. In an update process, after an iRD command shown in FIG. 4 is received, an active command count needs to be read out, and the active command count is updated, the active command count needs to be written to the counter cell after the iWR command shown in FIG. 4 is received. Correspondingly, tACU shown in FIG. 4 is a time of updating the counter cell.

The inventor also found that the MBIST test is a method of scanning word lines of a memory array (Bank) one by one to test whether there is a problem with each word line. The MBIST test does not have the problem of row hammer effect caused by frequent access to a single word line that PRHT aims to solve. Accordingly, the update to the counter cell during the MBIST test may cause an additional operating time. During the MBIST test, the test time is greatly increased, and a system startup time is further increased.

Based on this, an embodiment of the present disclosure provides an MBIST control solution, which may be applied to an MBIST test scenario of a memory. According to this embodiment of the present disclosure, the row count update may be stopped in the MBIST test mode, thereby saving an additional operation time of the counter cell update process, and improving MBIST test efficiency.

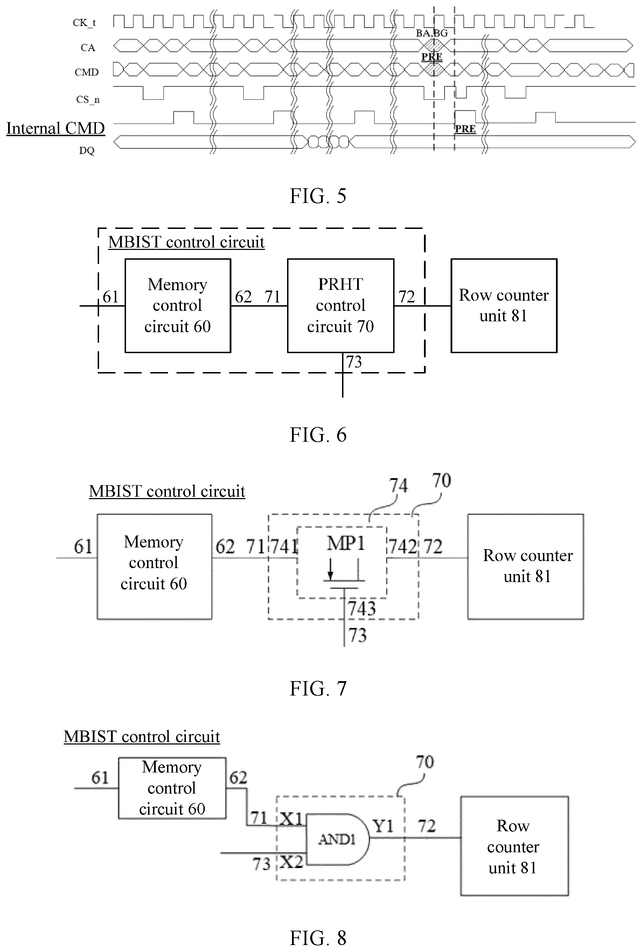

For example, FIG. 5 shows a timing control diagram of an MBIST test process according to an embodiment of the present disclosure. It can be learned from comparison between FIG. 5 and FIG. 4 that the technical solution provided in this embodiment of the present disclosure can help save a time of tACU and improve MBIST test efficiency.

The following describes the example implementations in detail with reference to the accompanying drawings and embodiments.

An embodiment of the present disclosure provides an MBIST control circuit, which may be disposed in a memory. In some embodiments, one MBIST control circuit may correspond to one or more memory arrays. For example, one MBIST control circuit may be corresponding to one memory array.

FIG. 6 shows a schematic diagram of a structure of an MBIST control circuit according to an embodiment of the present disclosure. As shown in FIG. 6, the MBIST control circuit provided in this embodiment of the present disclosure includes a memory control circuit 60 and a PRHT control circuit 70. Next, the circuits are described one by one.

The memory control circuit (Controller) 60 may include a first input terminal 61 and a first output terminal 62. The first input terminal 61 may be configured to receive an external precharge command of a target word line. The memory control circuit 60 may be configured to generate a counter update command in response to the external precharge command. The first output terminal 62 is configured to output the counter update command.

The counter update command is used to update a row counter unit of the target word line.

The target word line may be a word line that needs to be tested in an MBIST test process. In some embodiments, in a case in which the MBIST control circuit corresponds to at least one memory array of the memory, word lines of the at least one memory array are sequentially used as the target word line. In this embodiment, the word lines are sequentially used as the target word line, so that one MBIST test circuit can be disposed to control word lines of at least one memory array, thereby reducing control costs. In a process of performing problem scanning on the word lines of the at least one memory array one by one, MBIST control may be performed on the multiple word lines one by one, thereby improving the orderliness of the test. In some embodiments, one word line may be randomly selected from the word lines of the at least one memory array as the target word line. A manner of selecting the target word line is not limited in this embodiment of the present disclosure.

For example, the memory control circuit 60 may be a circuit that has a control function in the memory. This is not specifically limited.

After the memory control circuit 60 is described, the PRHT control circuit 70 is further described.

The PRHT control circuit 70 may include a second input terminal 71, a second output terminal 72, and a first control terminal 73. The second input terminal 71 is connected to the first output terminal 62, and is configured to receive a counter update command sent by the first output terminal 62. The first control terminal 73 is configured to receive a PRHT control command. The PRHT control circuit 70 is configured to stop providing a counter update command to the second output terminal when the PRHT control command is in a first level state, so that the row counter unit 81 of the target word line connected to the second output terminal 72 stops updating when no counter update command is received.

Specifically, to facilitate understanding of the PRHT control circuit 70, concepts such as a PRHT control command and a row counter unit are first described before a specific function and structure of the PRHT control circuit 70 are described.

The PRHT control command is used to control enabling or disabling of a PRHT operation. For example, the first level state of the PRHT control command is used to indicate a state of being in an MBIST test mode. Optionally, a second level state of the PRHT control command is used to indicate a state of being in a normal mode, that is, a non-MBIST mode. One of the first level state and the second level state is a high level state, and the other of the first level state and the second level state is a low level state.

For example, the PRHT control command may be a negated signal (which may be represented as "/MBIST EN") of an MBIST enable signal. For example, a low level of the negated signal may be used as the first level state of the PRHT control command, and a high level of the negated signal may be used as the second level state of the PRHT control command. The level of the MBIST enable signal can accurately represent the MBIST test mode or the normal mode. Correspondingly, the negated signal of the MBIST enable signal is used as the PRHT control command. Therefore, transmission of the counter update command can be accurately controlled to stop in the MBIST test mode based on the level of the negated signal, thereby improving MBIST control precision. In addition, a time at which the level of the negated signal is switched to the first level state can be completely aligned with a time of entering the MBIST test mode. Therefore, timely PRHT control is performed based on the first level state of the negated signal when the MBIST test mode is entered, thereby improving accuracy and timeliness of the MBIST control.

For another example, the PRHT control command may be an MBIST enable signal, which may be represented as "MBIST EN". For example, a high level of the MBIST enable signal may be used as the first level state of the PRHT control command, and a low level of the MBIST enable signal may be used as the second level state of the PRHT control command.

It should be noted that the PRHT control command may alternatively be another signal that can represent whether the MBIST test mode is entered. This is not specifically limited.

After the PRHT control command is described, the row counter unit 81 is described as follows.

The row counter unit (Row Counter Cell) 81 may be a memory cell configured to store an active command count of a target row. For example, still referring to FIG. 3, the row counter unit 81 may be located at a location P1 of each row. The active command count is a statistical result of a quantity of active commands received on the target row.

In some embodiments, the row counter unit 81 may stop updating the stored active command count when no counter update command is received.

After the counter unit is briefly described, a specific function and structure of the PRHT control circuit 70 are further described.

In some embodiments, the PRHT control circuit 70 may be specifically configured to pull the counter update command to a target level state when the PRHT control command is in the first level state. The row counter unit 81 does not respond to the target level state. For example, the target level state may be a low level state when the row counter unit 81 does not respond to a low level signal. Alternatively, the target level state may be a high level state when the row counter unit 81 does not respond to a high level signal.

Optionally, the PRHT control circuit 70 may be further configured to pull the counter update command to a level state opposite to the target level state when the PRHT control command is in the second level state. The low level state and the high level state are opposite to each other.

In this embodiment, whether the row counter unit 81 performs updating may be controlled by pulling down or pulling up the counter update command, which improves control convenience and control precision.

In an example, FIG. 7 shows a schematic diagram of a structure of an example MBIST control circuit according to an embodiment of the present disclosure. As shown in FIG. 7, the PRHT control circuit 70 includes a switch unit 74.

The switch unit 74 includes a first connection terminal 741, a second connection terminal 742, and a switch control terminal 743. The first connection terminal 741 serves as the second input terminal 71 of the PRHT control circuit 70. The second connection terminal 742 serves as the second output terminal 72 of the PRHT control circuit 70. The switch control terminal 743 serves as the first control terminal 73 of the PRHT control circuit 70. The switch control terminal 743 is configured to control the first connection terminal 741 and the second connection terminal 742 to be disconnected when a first level (that is, a level corresponding to the first level state) is applied. In this case, the counter update command cannot be transmitted to the row counter unit 81. In addition, the switch control terminal 743 is configured to control the first connection terminal 741 and the second connection terminal 742 to be connected when a second level (that is, a level corresponding to the second level state) is applied. In this case, the counter update command may be transmitted to the row counter unit 81.

In an example, the switch unit 74 may be implemented as a transistor with a control pin such as a metal oxide semi-conductor field effect transistor (MOS FET), for example, the P-type MOS transistor MP1 shown in FIG. 7. A source of the P-type MOS transistor MP1 is used as the first connection terminal 741, a drain of the P-type MOS transistor MP1 is used as the second connection terminal 742, and a gate of the P-type MOS transistor MP1 is used as the switch control terminal 743.

It should be noted that the switch unit 74 may alternatively be a circuit or component that has a switch function other than a transistor. This is not specifically limited.

In this embodiment, according to the PRHT control command received by the switch control terminal of the switch unit 74, whether the count update command continues to be transmitted can be accurately controlled by controlling the on-off mode of the transmission path of the counter update command, thereby ensuring MBIST control accuracy. The MBIST control circuit is simple in structure and easy to implement, and control costs are reduced.

In another example, FIG. 8 shows a schematic diagram of a structure of another example MBIST control circuit according to an embodiment of the present disclosure. As shown in FIG. 8, the PRHT control circuit 70 includes an AND gate unit AND 1. The AND gate unit AND1 includes a third logic input terminal X1, a fourth logic input terminal X2, and a second logic output terminal Y1.

The third logic input terminal X1 serves as the second input terminal 71 of the PRHT control circuit 70. The second logic output terminal Y1 serves as the second output terminal 72 of the PRHT control circuit 70, and the second logic output terminal Y1 serves as the first control terminal 73 of the PRHT control circuit 70.

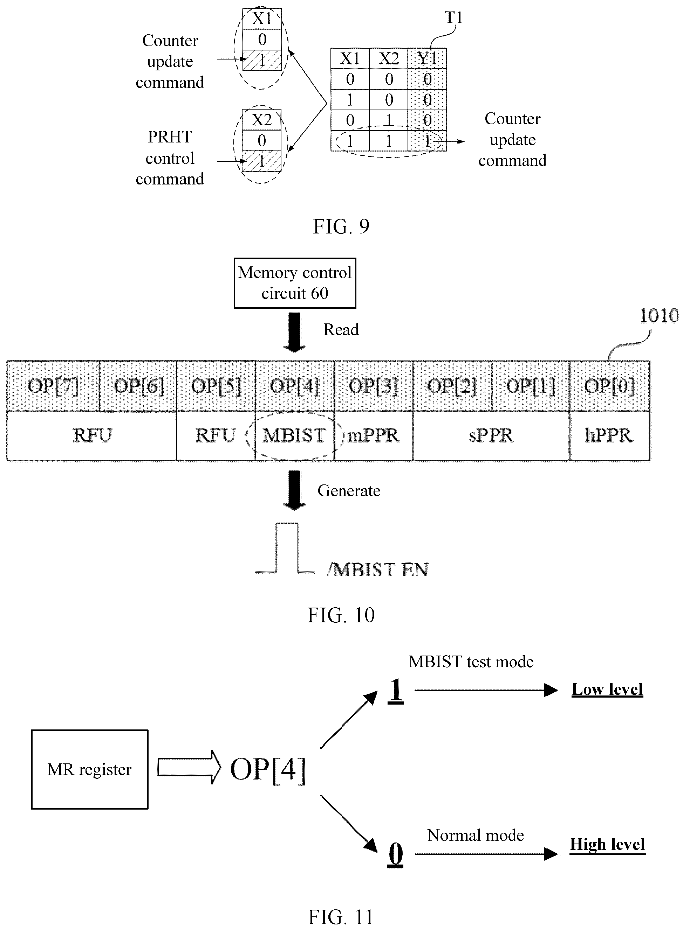

FIG. 9 shows a schematic logic diagram of signal transmission of the AND gate unit according to an embodiment of the present disclosure. As shown in FIG. 9, a control logic of the AND gate unit AND1 is shown in the truth table T11. Specifically, a counter update command of the third logic input terminal X1 is in a high level state, and corresponds to a logical value "1". In this case, if the fourth logic input terminal X2 is in the high level state (corresponding to the second level state of the PRHT control command), the second logic output terminal Y1 outputs a high level corresponding to a logical value "1". In this case, the output high level may be used as an output counter update command.

In addition, if the fourth logic input terminal X2 is in the low level state (corresponding to the first level state of the PRHT control command), regardless of the logical value corresponding to the counter update command, the second logic output terminal Y1 outputs a low level corresponding to the logical value "0". In this case, the counter update command cannot be output.

It should be noted that the PRHT control circuit 70 in this embodiment of the present disclosure may further be implemented as another circuit, component, functional circuit, logic gate component, and combination thereof that can control transmission of the counter update command. This is not specifically limited.

In some embodiments, the PRHT control circuit 70 is further configured to:
provide the counter update command to the second output terminal when the PRHT control command is in the second level state, so that the row counter unit 81 updates the active command count of the target word line based on the counter update command. For example, the active command count may be increased by 1 on the basis of the original value, to obtain an updated active command count.

Because the second level state of the PRHT control command represents that the memory is in the normal mode (normal operation mode), in this embodiment, in the normal mode, the PRHT control circuit 70 may send a counter update command to the row counter unit 81, so as to accumulate and update the active command count, thereby ensuring normal operation of the PRHT function in the normal mode.

It should be noted that the PRHT control circuit 70 may further implement another function according to an actual situation and a specific requirement. This is not specifically limited.

According to the MBIST control circuit provided in this embodiment of the present disclosure, when receiving the counter update command generated by the memory control circuit based on the external precharge command, the PRHT control circuit may control the row counter unit 81 to stop updating in a manner of stopping sending the counter update command to the row counter unit 81 when the PRHT control command is in the first level state. Because the first level state of the PRHT control command is used to indicate a state of being in the MBIST test mode, according to this embodiment of the present disclosure, the row count update may be stopped in the MBIST test mode, thereby saving an additional operation time of the counter cell update process, and improving MBIST test efficiency.

In addition, according to this embodiment of the present disclosure, the PRHT function may be automatically disabled in the MBIST test mode, thereby improving reliability of the MBIST test.

In some embodiments, the memory control circuit 60 is further configured to obtain a bit sequence stored in a mode register (MR); and generate a PRHT control command based on a bit value of a preset field of the bit sequence.

For example, FIG. 10 shows a schematic logic diagram of a processing logic of a memory control circuit according to an embodiment of the present disclosure. As shown in FIG. 10, the memory control circuit 60 may read a bit sequence 1010 from an MR register. The OP[4] field of the bit sequence defines whether the memory is in the MBIST test mode. For example, FIG. 11 shows a schematic logic diagram of generating a negated signal of an MBIST enable signal. As shown in FIG. 11, when a memory value of the OP[4] field of the bit sequence is 1, it indicates that the memory is in the MBIST test mode (MBIST Enable). When the memory value of the OP[4] field is 0, it indicates that the memory is in the normal mode (MBIST Disabled).

After the memory value of the OP[4] field is obtained, the negated signal (PRHT control command) of the MBIST enable signal may be obtained. For example, still referring to FIG. 11, when the memory value is 1, a negated signal (/MBIST EN) corresponding to an MBIST enable signal with a low level (in the first level state) may be generated. Similarly, when the memory value is 0, a negated signal corresponding to an MBIST enable signal with a high level (in the second level state) is generated.

Optionally, the memory control circuit 60 may further generate an MBIST enable signal. A specific process of generating the MBIST enable signal is similar to an implementation of generating the negated signal of the MBIST enable signal. Details are not described herein again.

A controller (CPU) may control the memory to enter the MBIST test mode in a manner of configuring a specific value of a preset field of the MR register. Correspondingly, whether the memory is currently in the MBIST test mode or the normal mode can be accurately determined with data stored in the MR register. By reading the PRHT control command generated by the bit sequence of the MR register, it can accurately represent whether the memory has entered the MBIST test mode. Therefore, the MBIST test mode can be accurately controlled with the PRHT control command, thereby improving control precision.

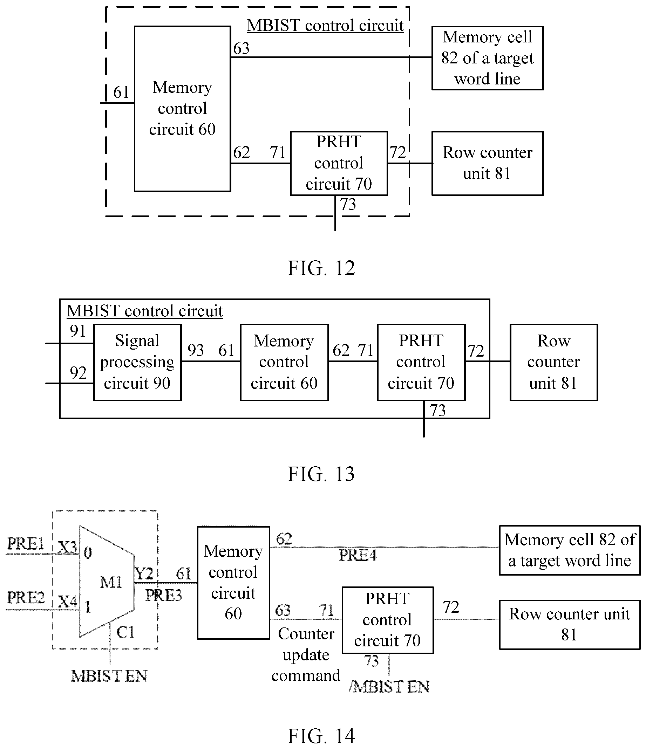

In some embodiments, FIG. 12 shows a schematic diagram of a structure of another MBIST control circuit according to an embodiment of the present disclosure. A difference between FIG. 12 and FIG. 6 lies in that the memory control circuit 60 further includes a fifth output terminal 63.

Correspondingly, the memory control circuit 60 is further configured to generate an internal precharge command in response to an external precharge command. The fifth output terminal 53 is configured to output the internal precharge command, so that the memory cell (Row Cell) 82 of the target word line performs a precharge operation in response to the internal precharge command.

For example, the memory cell 82 of the target word line may be a memory cell located on the target word line.

It should be noted that in this embodiment of the present disclosure, in the normal mode, the memory control circuit 60 may send a precharge command to the memory cell 82 of the target word line, and send a counter update command to the row counter unit 81, so as to accumulate and update the active command count, thereby ensuring normal development of the PRHT function in the normal mode. In the MBIST mode, the memory control circuit 60 may send a precharge command to the memory cell 82 of the target word line, so that MBIST test is implemented on the target word line, and test efficiency is improved by prohibiting the update of the row counter unit 81.

In this embodiment, an internal precharge command may be generated according to an external precharge command, so that the memory can normally respond to the external precharge command in either the MBIST test mode or the normal mode (that is, the non-MBIST test mode), thereby improving the orderliness of working of the memory.

In some embodiments, the row counter unit 81 is further configured to: send a feedback signal to the control host when the active command count is greater than or equal to a preset quantity threshold, so that the control host sends, in response to the feedback signal, an RFM command to a memory to which the target word line belongs. The preset quantity threshold may be set to an empirical value or a calculated value according to an actual situation and a specific requirement. This is not specifically limited.

In some embodiments, the memory may send a feedback signal to the control host by pulling down the ALERT_n pin. Optionally, the feedback signal is used to feed back to the control host that the target word line is frequently activated, and a row hammer effect exists in a neighboring word line of the target word line.

In some embodiments, after receiving the RFM command, the memory may refresh the neighboring word line of the target word line, so as to avoid occurrence of a row hammer effect.

In this embodiment, the row counter unit 81 may feedback timely to the control host when the active command count is greater than or equal to the preset quantity threshold, so that the row hammer effect can be timely warned, and the control host can timely process alarm information, thereby ensuring performance and reliability of the memory.

FIG. 13 shows a schematic diagram of a structure of still another MBIST control circuit according to an embodiment of the present disclosure. As shown in FIG. 13, the MBIST control circuit provided in this embodiment of the present disclosure includes a memory control circuit 60, a PRHT control circuit 70, and a signal processing circuit 90. For the memory control circuit 60 and the PRHT control circuit 70, refer to the foregoing description in the embodiments of the present disclosure. The signal processing circuit 90 is described as follows.

The signal processing circuit 90 includes a third input terminal 91, a fourth input terminal 92, and a third output terminal 93. The third input terminal 91 is configured to receive a first precharge command for a target word line that is sent by the control host. The fourth input terminal 92 is configured to receive a second precharge command for the target word line that is sent by an MBIST test system. The signal processing circuit 90 is configured to generate an external precharge command when the first precharge command and/or the second precharge command are/is received. The third output terminal 93 is configured to output the external precharge command.

In an example, FIG. 14 shows a schematic diagram of a structure of still another example MBIST control circuit according to an embodiment of the present disclosure. As shown in FIG. 14, the signal processing circuit 90 may include a data selector M1.

The data selector M1 includes a second control terminal C1, a first data input terminal X3, a second data input terminal X4, and a data output terminal Y2.

The second control terminal C1 is configured to receive an MBIST enable signal, for example, MBIST EN in FIG. 14.

The first data input terminal X3 serves as the third input terminal 91 of the signal processing circuit 90, and may be configured to receive a first precharge command PRE1 sent by the control host.

The second data input terminal X4 serves as the fourth input terminal 92 of the signal processing circuit 90, and may be configured to receive a second precharge command PRE2 sent by the MBIST test system.

The data output terminal Y2 serves as the third output terminal 93 of the signal processing circuit 90, and is configured to output an external precharge command PRE3. Specifically, the data output terminal Y2 is configured to: output the first precharge command PRE1 received at the first data input terminal X3 as the external precharge command PRE3 when the MBIST enable signal MBIST EN is in the third level state, and output the second precharge command PRE received at the second data input terminal X4 as the external precharge command PRE3 when the MBIST enable signal MBIST EN is in the fourth level state.

One of the third level state and the fourth level state is a high level state, and the other of the third level state and the fourth level state is a low level state.

For example, still referring to FIG. 14, if the first data input terminal X3 is turned on at a low level (corresponding to the "0" port in FIG. 14), the third level state is a low level state, and correspondingly, the fourth level state is a high level state.

It should be noted that in this embodiment of the present disclosure, another component having a data selection function may be used to implement the foregoing functions, and details are not described herein again.

In this example, with a data selector, flexible gating may be performed on the first precharge command and the second precharge command in an either-or manner. This ensures that the memory control circuit 60 can receive an accurate external precharge command, and ensures the orderliness of control of the MBIST control circuit.

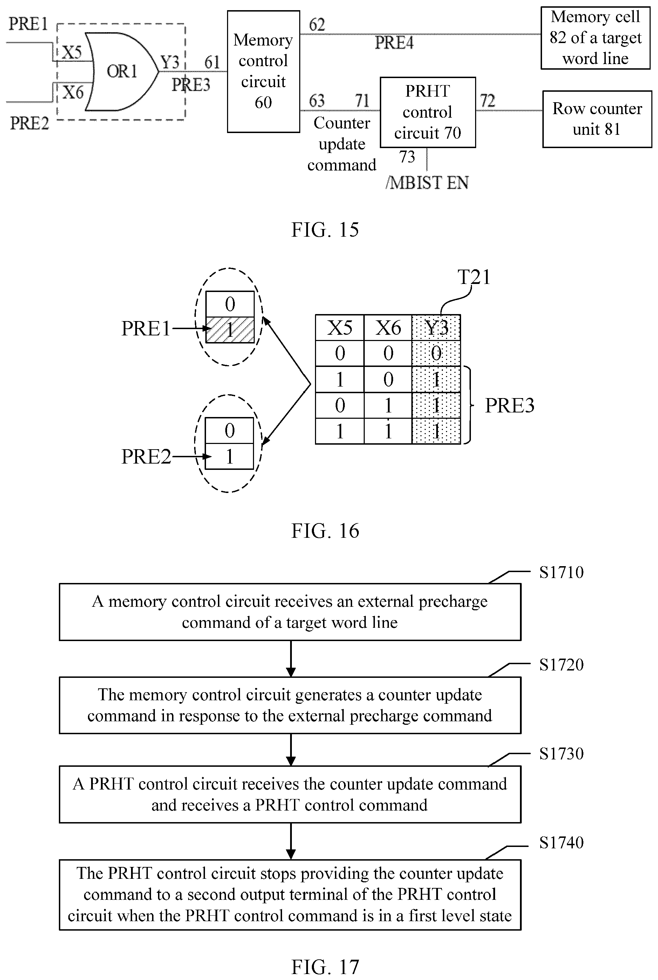

In an example, FIG. 15 shows a schematic diagram of a structure of yet another example MBIST control circuit according to an embodiment of the present disclosure.

As shown in FIG. 15, the signal processing circuit 90 may include an OR gate unit OR1. The OR gate unit OR1 includes a first logic input terminal X5, a second logic input terminal X6, and a first logic output terminal Y3.

The first logic input terminal X5 serves as the third input terminal 91 of the signal processing circuit 90, and the first precharge command corresponds to a high level signal.

The second logic input terminal X6 serves as the fourth input terminal 92 of the signal processing circuit 90, and the second precharge command corresponds to a high level signal.

The first logic output terminal Y3 serves as the third output terminal 93 of the signal processing circuit 90. Specifically, the first logic output terminal Y3 is configured to output a high level signal as the external precharge command when the first logic input terminal X5 and/or the second logic input terminal X6 receive/receives the high level signal.

For example, FIG. 16 shows a schematic logic diagram of signal transmission of an OR gate unit according to an embodiment of the present disclosure. As shown in FIG. 16, a control logic of the OR gate unit OR1 is shown in the truth table T21.

Specifically, the first precharge command PRE1 and the second precharge command PRE2 are corresponding to a logical value "1", that is, a high level state. When the first logic input terminal X5 and/or the second logic input terminal X6 are corresponding to the logical value "1", the first logic output terminal Y3 outputs a high level signal as the external precharge command.

In this example, when the first precharge command and the second precharge command are received, an external precharge command may be accurately generated with the OR gate. This ensures that the memory control circuit 60 can receive an accurate external precharge command, and ensures the orderliness of control of the MBIST control circuit.

It should be noted that the signal processing circuit 90 in this embodiment of the present disclosure may further be implemented as another circuit, component, functional circuit, logic gate component, and combination thereof that can generate an external precharge command according to multiple externally transmitted precharge commands. This is not specifically limited.

According to the MBIST control circuit provided in this embodiment of the present disclosure, when receiving the counter update command generated by the memory control circuit based on the external precharge command, the PRHT control circuit may control the row counter unit 81 to stop updating in a manner of stopping sending the counter update command to the row counter unit 81 when the PRHT control command is in the first level state. Because the first level state of the PRHT control command is used to indicate a state of being in the MBIST test mode, according to this embodiment of the present disclosure, the row count update may be stopped in the MBIST test mode, thereby saving an additional operation time of the counter cell update process, and improving MBIST test efficiency.

According to this embodiment of the present disclosure, with the signal processing circuit 90, a control logic disorder caused when the memory control circuit 90 receives multiple precharge commands sent by multiple external devices (such as control hosts or MBIST test systems) can be avoided, thereby ensuring reliability of the MBIST test.

It should be noted that in this embodiment of the present disclosure, a control logic other than the signal processing circuit 90 may be used to ensure that the memory control circuit 90 responds correctly to a precharge command transmitted externally. This is not specifically limited.

Based on a same invention concept, an embodiment of the present disclosure further provides an MBIST control method, which is applied to the MBIST control circuit shown in any one of the foregoing embodiments. The control method is described in the following embodiments.

FIG. 17 shows a schematic flowchart of an MBIST control method according to an embodiment of the present disclosure. As shown in FIG. 17, the MBIST control method includes S1710 to S1740.

In S1710, a memory control circuit receives an external precharge command of a target word line.

In S1720, the memory control circuit generates a counter update command in response to the external precharge command.

In S1730, a PRHT control circuit receives the counter update command and receives a PRHT control command. In some embodiments, the PRHT control command is a negated signal of the MBIST enable signal.

In S1740, the PRHT control circuit stops providing a counter update command to a second output terminal when the PRHT control command is in a first level state, so that a row counter unit of the target word line connected to the second output terminal stops updating when no counter update command is received. The first level state of the PRHT control command is used to indicate a state of being in an MBIST test mode.

In some embodiments, S1740 specifically includes the following step D1.

In step D1, the PRHT control circuit pulls the counter update command to a target level state when the PRHT control command is in the first level state. The row counter unit does not respond to the target level state.

In some embodiments, the PRHT control circuit includes a switch unit.

The switch unit includes a first connection terminal, a second connection terminal, and a switch control terminal. The first connection terminal serves as the second input terminal, the second connection terminal serves as the second output terminal, and the switch control terminal serves as the first control terminal. The switch control terminal is configured to: control the first connection terminal and the second connection terminal to be disconnected when a first level is applied, and control the first connection terminal and the second connection terminal to be connected when a second level is applied.

According to the MBIST control circuit provided in this embodiment of the present disclosure, when receiving the counter update command generated by the memory control circuit based on the external precharge command, the PRHT control circuit may control the row counter unit to stop updating in a manner of stopping sending the counter update command to the row counter unit when the PRHT control command is in the first level state. Because the first level state of the PRHT control command is used to indicate a state of being in the MBIST test mode, according to this embodiment of the present disclosure, the row count update may be stopped in the MBIST test mode, thereby saving an additional operation time of the counter cell update process, and improving MBIST test efficiency.

In some embodiments, the MBIST control method further includes the following step E1.

In step E1, the PRHT control circuit provides the counter update command to the second output terminal when the PRHT control command is in the second level state, so that the row counter unit updates the active command count of the target word line based on the counter update command.

One of the first level state and the second level state is a high level state, and the other of the first level state and the second level state is a low level state.

In some embodiments, before step S1710, the MBIST control circuit further includes the following steps E21 to E24.

In step E21, a third input terminal of a signal processing circuit receives a first precharge command for the target word line that is sent by a control host.

In step E22, a fourth input terminal of the signal processing circuit receives a second precharge command for the target word line that is sent by an MBIST test system.

In step E23, the signal processing circuit is configured to generate an external precharge command when the first precharge command and/or the second precharge command are/is received.

In step E24, a third output terminal is configured to output the external precharge command.

In an embodiment, the signal processing circuit includes a data selector.

The data selector includes a second control terminal, a first data input terminal, a second data input terminal, and a data output terminal. The second control terminal is configured to receive an MBIST enable signal. The first data input terminal serves as the third input terminal of the signal processing circuit, the second data input terminal serves as the fourth input terminal of the signal processing circuit, and the data output terminal serves as the third output terminal of the signal processing circuit. The data output terminal is configured to: output the first precharge command received at the first data input terminal as the external precharge command when the MBIST enable signal is in a third level state, and output the second precharge command received at the second data input terminal as the external precharge command when the MBIST enable signal is in a fourth level state.

In another embodiment, the signal processing circuit includes an OR gate unit.

The OR gate unit includes a first logic input terminal, a second logic input terminal, and a first logic output terminal. The first logic input terminal serves as the third input terminal of the signal processing circuit, and the first precharge command corresponds to a high level signal. The second logic input terminal serves as the fourth input terminal of the signal processing circuit, and the second precharge command corresponds to a high level signal. The first logic output terminal serves as the third output terminal of the signal processing circuit. The first logic output terminal is configured to output a high level signal that serves as the external precharge command when the first logic input terminal and/or the second logic input terminal receive/receives the high level signal.

In some embodiments, before step S1710, the MBIST control circuit further includes the following step F11 and step F12.

In step F11, the memory control circuit obtains a bit sequence stored in a mode register.

In step F12, a PRHT control command is generated based on a bit value of a preset field of the bit sequence.

In some embodiments, the MBIST control circuit further includes the following steps F21 and F22.

In step F21, the memory control circuit generates an internal precharge command in response to the external precharge command.

In step F22, the fifth output terminal of the memory control circuit is configured to output the internal precharge command, so that the memory cell located on the target word line performs a precharge operation in response to the internal precharge command.

In some embodiments, the MBIST control circuit further includes the following step F3.

In step F3, the row counter unit sends a feedback signal to the control host when the active command count is greater than or equal to a preset quantity threshold, so that the control host sends, in response to the feedback signal, an RFM command to the memory to which the target word line belongs.

In some embodiments, the MBIST control circuit corresponds to at least one memory array of the memory.

Word lines of the at least one memory array are sequentially used as the target word line.

It should be noted that for the MBIST control method shown in FIG. 17, refer to descriptions in the apparatus embodiments shown in FIG. 6 to FIG. 16, and the processes and effects in the apparatus embodiments shown in FIG. 6 to FIG. 16 are implemented. Details are not described herein again.

Based on a same invention concept, an embodiment of the present disclosure further provides a memory. The memory may include a memory circuit and an MBIST control circuit.

The memory circuit may include multiple memory arrays, and
the MBIST control circuit 60 provided in any one of the foregoing embodiments of the present disclosure. For specific content of the MBIST control circuit 60, refer to related descriptions in the foregoing parts of the embodiments of the present disclosure with reference to FIG. 6 to FIG. 16. Details are not described again.

For example, the memory in this embodiment of the present disclosure may be any one of a fourth generation double data rate synchronous dynamic random access memory (DDR4 SDRAM), a fourth generation low-power double data rate synchronous dynamic random access memory (LPDDR4 SDRAM), a fifth generation double data rate synchronous dynamic random access memory (DDR5 SDRAM), or a fifth generation low-power double data rate synchronous dynamic random access memory (LPDDR5 SDRAM). This is not specifically limited. It should be noted that the memory may alternatively be a memory other than the dynamic random access memory. This is not specifically limited.

According to the memory provided in this embodiment of the present disclosure, when receiving the counter update command generated by the memory control circuit based on the external precharge command, the PRHT control circuit may control the row counter unit to stop updating in a manner of stopping sending the counter update command to the row counter unit when the PRHT control command is in the first level state. Because the first level state of the PRHT control command is used to indicate a state of being in the MBIST test mode, according to this embodiment of the present disclosure, the row count update may be stopped in the MBIST test mode, thereby saving an additional operation time of the counter cell update process, and improving MBIST test efficiency.

Based on the same inventive concept, an embodiment of the present disclosure further provides an electronic device. The electronic device may include the memory provided in any one of the foregoing embodiments of the present disclosure. For specific content of the memory, refer to related descriptions in the foregoing part of the embodiments of the present disclosure. Details are not described again.

The electronic device in this embodiment of the present disclosure may be an electronic device loaded with a memory. For example, the electronic device may be a mobile terminal, a computer, a server, a virtual reality device, or an internet of things device.

According to the electronic device provided in this embodiment of the present disclosure, when receiving the counter update command generated by the memory control circuit based on the external precharge command, the PRHT control circuit may control the row counter unit to stop updating in a manner of stopping sending the counter update command to the row counter unit when the PRHT control command is in the first level state. Because the first level state of the PRHT control command is used to indicate a state of being in the MBIST test mode, according to this embodiment of the present disclosure, the row count update may be stopped in the MBIST test mode, thereby saving an additional operation time of the counter cell update process, and improving MBIST test efficiency.

A person skilled in the art can understand that the aspects of the present disclosure may be implemented as systems, methods, or program products. Therefore, the aspects of the present disclosure may be specifically implemented in the following manners, that is, a complete hardware implementation, a complete software implementation (including firmware, micro code, or the like), or an implementation in which hardware and software aspects are combined, which may be collectively referred to as "circuit" or "system".

It should be noted that the embodiments in this specification are described in a progressive manner. For the same or similar part of the embodiments, mutual reference may be made to the embodiments. Each embodiment focuses on a difference from another embodiment. Description of the method embodiment is relatively simple. For related parts, refer to the description part of the system embodiment. The present disclosure is not limited to the specific steps and structures described above and shown in the figures. In addition, for brevity, detailed descriptions of a known method technology are omitted herein.

In several embodiments provided in the present disclosure, it should be understood that the disclosed system, apparatus, and method may be implemented in another manner. For example, the apparatus embodiments described above are merely examples. For example, the unit division is merely logical function division, and there may be another division manner in actual implementation. For example, multiple units or components may be combined or integrated into another system, or some features may be ignored or not performed. In addition, the displayed or discussed mutual couplings or direct couplings or communication connections may be implemented through some ports. The indirect couplings or communication connections between the apparatuses or units may be implemented in electronic, mechanical, or other forms.

The units described as separate parts may or may not be physically separate, and parts displayed as units may or may not be physical units, may be located at one position, or may be distributed on multiple network units. Some or all of the units may be selected according to an actual requirement to achieve the objectives of the solutions of the embodiments.

In addition, all functional units in the embodiments of the present disclosure may be integrated into one processing unit, or each unit may exist separately in a physical form, or two or more units may be integrated into one unit.

The foregoing is merely specific implementations of the present disclosure, but is not intended to limit the protection scope of the present disclosure. Any variation or replacement readily figured out by a person skilled in the art within the technical scope disclosed in the present disclosure shall fall within the protection scope of the present disclosure as long as they also fall within the scope of the claims.

Therefore, the protection scope of the present disclosure shall be subject to the protection scope of the claims. The present disclosure is intended to cover any variations, functions, or adaptive changes of the present disclosure as long as they fall within the scope of the claims. These variations, functions, or adaptive changes comply with general principles of the present disclosure, and include common knowledge or a conventional technical means in the art that is not disclosed in the present disclosure.

## Claims

1. A memory built-in self-test, MBIST, control circuit, comprising: a memory control circuit (60),
comprising a first input terminal (61) and a first output terminal (62), wherein the first input terminal is configured to receive an external command of a target word line, the memory control circuit is configured to generate a counter update command in response to the external command, and the first output terminal is configured to output the counter update command;
and a per row hammer tracking control circuit (70), comprising a second input terminal (71), a second output terminal (72), and a first control terminal (73), wherein the second input terminal is connected to the first output terminal, and is configured to receive the counter update command; the first control terminal is configured to receive a per row hammer tracking control command, the per row hammer tracking control circuit is configured to stop providing the counter update command to the second output terminal when the per row hammer tracking control command is in a first level state;
wherein the first level state of the per row hammer tracking control command is used to indicate a state of being in an MBIST test mode; **characterised in that**
the external command is an external precharge command; the counter update command is used to update a row counter unit (81) of the target word line; the row counter unit (81) of the target word line connected to the second output terminal stops updating when no counter update command is received; and that the row counter unit (81) is a memory cell configured to store an active command count of a target row.

2. The memory built-in self-test control circuit according to claim 1, wherein the per row hammer tracking control circuit is specifically configured to: pull the counter update command to a target level state when the per row hammer tracking control command is in the first level state, wherein the row counter unit does not respond to the target level state.

3. The memory built-in self-test control circuit according to claim 1 or 2, wherein the per row hammer tracking control circuit comprises: a switch unit (74), comprising a first connection terminal (741), a second connection terminal (742), and a switch control terminal (743), wherein the first connection terminal serves as the second input terminal, the second connection terminal serves as the second output terminal, the switch control terminal serves as the first control terminal, and the switch control terminal is configured to: control the first connection terminal and the second connection terminal to be disconnected when a first level is applied, and control the first connection terminal and the second connection terminal to be connected when a second level is applied.

4. The memory built-in self-test control circuit according to claim 1 or 2, wherein the per row hammer tracking control circuit comprises: an AND gate unit (AND 1), comprising a third logic input terminal (X1), a fourth logic input terminal (X2), and a second logic output terminal (Y1), wherein the third logic input terminal serves as the second input terminal, the second logic output terminal serves as the second output terminal, and the second logic output terminal serves as the first control terminal.

5. The memory built-in self-test control circuit according to any one of claims 1 to 4, wherein the per row hammer tracking control circuit is further configured to: provide the counter update command to the second output terminal when the per row hammer tracking control command is a second level state, so that the row counter unit updates an active command count of the target word line based on the counter update command; and one of the first level state and the second level state is a high level state, and the other of the first level state and the second level state is a low level state.

6. The memory built-in self-test control circuit according to any one of claims 1 to 5, wherein the circuit further comprises: a signal processing circuit (90), comprising a third input terminal (91), a fourth input terminal (92), and a third output terminal (93), wherein the third input terminal is configured to receive a first precharge command for the target word line that is sent by a control host (20); the fourth input terminal is configured to receive a second precharge command for the target word line that is sent by an MBIST test system; the signal processing circuit is configured to generate the external precharge command when the first precharge command and/or the second precharge command are/is received; and the third output terminal is configured to output the external precharge command.

7. The memory built-in self-test control circuit according to claim 6, wherein the signal processing circuit comprises: a data selector (M1), comprising a second control terminal (C1), a first data input terminal (X3), a second data input terminal (X4), and a data output terminal (Y2), wherein the second control terminal is configured to receive an MBIST enable signal, the first data input terminal serves as the third input terminal of the signal processing circuit, the second data input terminal serves as the fourth input terminal of the signal processing circuit, the data output terminal serves as the third output terminal of the signal processing circuit, and the data output terminal is configured to: output the first precharge command received at the first data input terminal as the external precharge command when the MBIST enable signal is in a third level state, and output the second precharge command received at the second data input terminal as the external precharge command when the MBIST enable signal is in a fourth level state.

8. The memory built-in self-test control circuit according to claim 6, wherein the signal processing circuit comprises: an OR gate unit (OR1), wherein the OR gate unit comprises a first logic input terminal (X5), a second logic input terminal (X6), and a first logic output terminal (Y3); the first logic input terminal serves as the third input terminal of the signal processing circuit, and the first precharge command corresponds to a high level signal; the second logic input terminal serves as the fourth input terminal of the signal processing circuit, and the second precharge command corresponds to a high level signal; the first logic output terminal serves as the third output terminal of the signal processing circuit; and the first logic output terminal is configured to output a high level signal that serves as the external precharge command when the first logic input terminal and/or the second logic input terminal receive/receives the high level signal.

9. The memory built-in self-test control circuit according to any one of claims 1 to 8, wherein the per row hammer tracking control command is a negated signal of the MBIST enable signal.

10. The memory built-in self-test control circuit according to any one of claims 1 to 9, wherein the memory control circuit is further configured to: obtain a bit sequence stored in a mode register; and generate the per row hammer tracking control command based on a bit value of a preset field of the bit sequence.

11. The memory built-in self-test control circuit according to any one of claims 1 to 10, wherein the memory control circuit further comprises: a fifth output terminal (63), wherein the memory control circuit is further configured to generate an internal precharge command in response to the external precharge command, and the fifth output terminal is configured to output the internal precharge command, so that a memory cell (82) located on the target word line performs a precharge operation in response to the internal precharge command.

12. The memory built-in self-test control circuit according to any one of claims 1 to 11, wherein the row counter unit is further configured to: send a feedback signal to the control host when the active command count is greater than or equal to a preset quantity threshold, so that the control host sends, in response to the feedback signal, an RFM command to a memory to which the target word line belongs.

13. The memory built-in self-test control circuit according to any one of claims 1 to 12, wherein the MBIST control circuit corresponds to at least one memory array (11) of the memory; and word lines of the at least one memory array are sequentially used as the target word line.

14. An MBIST control method, comprising: receiving, by a memory control circuit (60), an external precharge command of a target word line; generating, by the memory control circuit, a counter update command in response to the external precharge command, wherein the counter update command is used to update a row counter unit of the target word line; receiving, by a per row hammer tracking control circuit (70), the counter update command and receiving a per row hammer tracking control command; and stopping, by the per row hammer tracking control circuit, providing the counter update command to a second output terminal of the per row hammer tracking control circuit when the per row hammer tracking control command is in a first level state, so that a row counter unit (81) of the target word line connected to the second output terminal stops updating when the counter update command is not received; wherein the row counter unit (81) is a memory cell configured to store an active command count of a target row; wherein the first level state of the per row hammer tracking control command is used to indicate a state of being in an MBIST test mode.

15. A memory, comprising: at least one memory array (11); and the MBIST control circuit according to any one of claims 1 to 13.

## Patentansprüche

1. Speicher-Built-In-Selbsttest-, MBIST, -Steuerschaltung, umfassend: eine Speichersteuerschaltung (60)
mit einem ersten Eingangsanschluss (61) und einem ersten Ausgangsanschluss (62), wobei der erste Eingangsanschluss dazu ausgebildet ist, einen externen Befehl einer Zielwortleitung zu empfangen, die Speichersteuerschaltung dazu ausgebildet ist, als Reaktion auf den externen Befehl einen Zähleraktualisierungsbefehl zu erzeugen, und der erste Ausgangsanschluss dazu ausgebildet ist, den Zähleraktualisierungsbefehl auszugeben; und
eine zeilenweise Hammer-Verfolgungssteuerschaltung (70) mit einem zweiten Eingangsanschluss (71), einem zweiten Ausgangsanschluss (72) und einem ersten Steueranschluss (73), wobei der zweite Eingangsanschluss mit dem ersten Ausgangsanschluss verbunden und dazu ausgebildet ist, den Zähleraktualisierungsbefehl zu empfangen; der erste Steueranschluss dazu ausgebildet ist, einen zeilenweisen Hammer-Verfolgungssteuerbefehl zu empfangen, die zeilenweise Hammer-Verfolgungssteuerschaltung dazu ausgebildet ist, wenn der zeilenweise Hammer-Verfolgungssteuerbefehl in einem ersten Pegelzustand ist, das Bereitstellen des Zähleraktualisierungsbefehls an den zweiten Ausgangsanschluss zu stoppen;
wobei der erste Pegelzustand des zeilenweisen Hammer-Verfolgungssteuerbefehls dazu dient, einen Zustand anzugeben, der sich im MBIST-Testmodus befindet; **dadurch gekennzeichnet, dass**
der externe Befehl ein externer Vorladungsbefehl ist; der Zähleraktualisierungsbefehl dazu dient, eine Zeilenzählereinheit (81) der Zielwortleitung zu aktualisieren; die mit dem zweiten Ausgangsanschluss verbundene Zeilenzählereinheit (81) der Zielwortleitung ihre Aktualisierung stoppt, wenn kein Zähleraktualisierungsbefehl empfangen wird; und dass die Zeilenzählereinheit (81) eine Speicherzelle ist, die dazu ausgebildet ist, eine Aktivierungsbefehlszählung einer Zielzeile zu speichern.

2. MBIST-Steuerschaltung nach Anspruch 1, wobei die zeilenweise Hammer-Verfolgungssteuerschaltung insbesondere dazu ausgebildet ist: wenn der zeilenweise Hammer-Verfolgungssteuerbefehl in dem ersten Pegelzustand ist, den Zähleraktualisierungsbefehl auf einen Zielpegelzustand zu ziehen, wobei die Zeilenzählereinheit auf den Zielpegelzustand nicht reagiert.

3. MBIST-Steuerschaltung nach Anspruch 1 oder 2, wobei die zeilenweise Hammer-Verfolgungssteuerschaltung umfasst: eine Schalteinheit (74) mit einem ersten Verbindungsanschluss (741), einem zweiten Verbindungsanschluss (742) und einem Schaltersteueranschluss (743), wobei der erste Verbindungsanschluss als der zweite Eingangsanschluss dient, der zweite Verbindungsanschluss als der zweite Ausgangsanschluss dient, der Schaltersteueranschluss als der erste Steueranschluss dient, und der Schaltersteueranschluss dazu ausgebildet ist: bei Anlegen eines ersten Pegels den ersten Verbindungsanschluss und den zweiten Verbindungsanschluss zu steuern, um getrennt zu werden, und bei Anlegen eines zweiten Pegels den ersten Verbindungsanschluss und den zweiten Verbindungsanschluss zu steuern, um verbunden zu werden.

4. MBIST-Steuerschaltung nach Anspruch 1 oder 2, wobei die zeilenweise Hammer-Verfolgungssteuerschaltung umfasst: eine UND-Gattereinheit (AND1) mit einem dritten logischen Eingangsanschluss (X1), einem vierten logischen Eingangsanschluss (X2) und einem zweiten logischen Eingangsanschluss (Y1), wobei der dritte logische Eingangsanschluss als der zweite Eingangsanschluss dient, der zweite logische Eingangsanschluss als der zweite Ausgangsanschluss dient, und der zweite logische Eingangsanschluss als der erste Steueranschluss dient.

5. MBIST-Steuerschaltung nach einem der Ansprüche 1 bis 4, wobei die zeilenweise Hammer-Verfolgungssteuerschaltung ferner dazu ausgebildet ist: wenn der zeilenweise Hammer-Verfolgungssteuerbefehl in einem zweiten Pegelzustand ist, den Zähleraktualisierungsbefehl an den zweiten Ausgangsanschluss bereitzustellen, sodass die Zeilenzählereinheit basierend auf dem Zähleraktualisierungsbefehl eine Aktivierungsbefehlszählung der Zielwortleitung aktualisiert; und einer des ersten Pegelzustands und des zweiten Pegelzustands ein hoher Pegelzustand ist und der andere des ersten Pegelzustands und des zweiten Pegelzustands ein niedriger Pegelzustand ist.

6. MBIST-Steuerschaltung nach einem der Ansprüche 1 bis 5, wobei die Schaltung ferner umfasst: eine Signalverarbeitungsschaltung (90) mit einem dritten Eingangsanschluss (91), einem vierten Eingangsanschluss (92) und einem dritten Ausgangsanschluss (93), wobei der dritte Eingangsanschluss dazu ausgebildet ist, einen von einem Steuerhost (20) gesendeten ersten Vorladungsbefehl für die Zielwortleitung zu empfangen; der vierte Eingangsanschluss dazu ausgebildet ist, einen von einem MBIST-Testsystem gesendeten zweiten Vorladungsbefehl für die Zielwortleitung zu empfangen; die Signalverarbeitungsschaltung dazu ausgebildet ist, den externen Vorladungsbefehl zu erzeugen, wenn der erste Vorladungsbefehl und/oder der zweite Vorladungsbefehl empfangen wird/werden; und der dritte Ausgangsanschluss dazu ausgebildet ist, den externen Vorladungsbefehl auszugeben.

7. MBIST-Steuerschaltung nach Anspruch 6, wobei die Signalverarbeitungsschaltung umfasst: einen Datenselektor (M1) mit einem zweiten Steueranschluss (C1), einem ersten Dateneingangsanschluss (X3), einem zweiten Dateneingangsanschluss (X4) und einem Datenausgangsanschluss (Y2), wobei der zweite Steueranschluss dazu ausgebildet ist, ein MBIST-Freigabesignal zu empfangen, der erste Dateneingangsanschluss als der dritte Eingangsanschluss der Signalverarbeitungsschaltung dient, der zweite Dateneingangsanschluss als der vierte Eingangsanschluss der Signalverarbeitungsschaltung dient, der Datenausgangsanschluss als der dritte Ausgangsanschluss der Signalverarbeitungsschaltung dient, und der Datenausgangsanschluss dazu ausgebildet ist: wenn das MBIST-Freigabesignal in einem dritten Pegelzustand ist, den am ersten Dateneingangsanschluss empfangenen ersten Vorladungsbefehl als den externen Vorladungsbefehl auszugeben, und wenn das MBIST-Freigabesignal in einem vierten Pegelzustand ist, den am zweiten Dateneingangsanschluss empfangenen zweiten Vorladungsbefehl als den externen Vorladungsbefehl auszugeben.

8. MBIST-Steuerschaltung nach Anspruch 6, wobei die Signalverarbeitungsschaltung umfasst: eine ODER-Gattereinheit (OR1), wobei die ODER-Gattereinheit einen ersten Logikeingangsanschluss (X5), einen zweiten Logikeingangsanschluss (X6) und einen ersten Logikausgangsanschluss (Y3) aufweist; der erste Logikeingangsanschluss als der dritte Eingangsanschluss der Signalverarbeitungsschaltung dient, und der erste Vorladungsbefehl einem Hochpegelsignal entspricht; der zweite Logikeingangsanschluss als der vierte Eingangsanschluss der Signalverarbeitungsschaltung dient, und der zweite Vorladungsbefehl einem Hochpegelsignal entspricht; der erste Logikausgangsanschluss als der dritte Ausgangsanschluss der Signalverarbeitungsschaltung dient; und der erste Logikausgangsanschluss dazu ausgebildet ist, ein Hochpegelsignal als den externen Vorladungsbefehl auszugeben, wenn der erste Logikeingangsanschluss und/oder der zweite Logikeingangsanschluss das Hochpegelsignal empfängt/empfangen.

9. MBIST-Steuerschaltung nach einem der Ansprüche 1 bis 8, wobei der zeilenweise Hammer-Verfolgungssteuerbefehl ein invertiertes Signal des MBIST-Freigabesignals ist.

10. MBIST-Steuerschaltung nach einem der Ansprüche 1 bis 9, wobei die Speichersteuerschaltung ferner dazu ausgebildet ist: eine in einem Modusregister gespeicherte Bitfolge zu erhalten; und den zeilenweisen Hammer-Verfolgungssteuerbefehl basierend auf einem Bitwert eines vorbestimmten Feldes der Bitfolge zu erzeugen.

11. MBIST-Steuerschaltung nach einem der Ansprüche 1 bis 10, wobei die Speichersteuerschaltung ferner umfasst: einen fünften Ausgangsanschluss (63), wobei die Speichersteuerschaltung ferner dazu ausgebildet ist, als Reaktion auf den externen Vorladungsbefehl einen internen Vorladungsbefehl zu erzeugen, und der fünfte Ausgangsanschluss dazu ausgebildet ist, den internen Vorladungsbefehl auszugeben, sodass eine auf der Zielwortleitung angeordnete Speicherzelle (82) als Reaktion auf den internen Vorladungsbefehl eine Vorladungsoperation durchführt.

12. MBIST-Steuerschaltung nach einem der Ansprüche 1 bis 11, wobei die Zeilenzählereinheit ferner dazu ausgebildet ist: wenn die Aktivierungsbefehlszählung größer oder gleich einem vorgegebenen Anzahlschwellwert ist, ein Rückmeldesignal an den Steuerhost zu senden, sodass der Steuerhost als Reaktion auf das Rückmeldesignal einen RFM-Befehl an einen Speicher, zu dem die Zielwortleitung gehört, sendet.

13. MBIST-Steuerschaltung nach einem der Ansprüche 1 bis 12, wobei die MBIST-Steuerschaltung zumindest einem Speicherarray (11) des Speichers zugeordnet ist; und Wortleitungen des zumindest einen Speicherarrays nacheinander als die Zielwortleitung verwendet werden.

14. MBIST-Steuerverfahren, umfassend: Empfangen, durch eine Speichersteuerschaltung (60), eines externen Vorladungsbefehls einer Zielwortleitung; Erzeugen eines Zähleraktualisierungsbefehls als Reaktion auf den externen Vorladungsbefehl durch die Speichersteuerschaltung, wobei der Zähleraktualisierungsbefehl dazu dient, eine Zeilenzählereinheit der Zielwortleitung zu aktualisieren; Empfangen, durch eine zeilenweise Hammer-Verfolgungssteuerschaltung (70), des Zähleraktualisierungsbefehls und Empfangen eines zeilenweisen Hammer-Verfolgungssteuerbefehls; und Stoppen, durch die zeilenweise Hammer-Verfolgungssteuerschaltung, des Bereitstellens des Zähleraktualisierungsbefehls an einen zweiten Ausgangsanschluss der zeilenweisen Hammer-Verfolgungssteuerschaltung, wenn der zeilenweise Hammer-Verfolgungssteuerbefehl in einem ersten Pegelzustand ist, sodass eine mit dem zweiten Ausgangsanschluss verbundene Zeilenzählereinheit (81) der Zielwortleitung Aktualisierung stoppt, wenn der Zähleraktualisierungsbefehl nicht empfangen wird; wobei die Zeilenzählereinheit (81) eine Speicherzelle ist, die dazu ausgebildet ist, eine Aktivierungsbefehlszählung einer Zielzeile zu speichern; wobei der erste Pegelzustand des zeilenweisen Hammer-Verfolgungssteuerbefehls dazu dient, einen Zustand anzugeben, der sich im MBIST-Testmodus befindet.

15. Speicher, umfassend: zumindest ein Speicherarray (11); und die MBIST-Steuerschaltung nach einem der Ansprüche 1 bis 13.

## Revendications

1. Circuit de commande d'auto-test intégré de mémoire, MBIST, comprenant : un circuit de commande de mémoire (60),
comprenant une première borne d'entrée (61) et une première borne de sortie (62), la première borne d'entrée étant configurée pour recevoir une instruction externe d'une ligne de mots cible, le circuit de commande de mémoire étant configuré pour générer une instruction de mise à jour de compteur en réponse à l'instruction externe, et la première borne de sortie étant configurée pour émettre l'instruction de mise à jour de compteur ;
et un circuit de commande de suivi de martèlement par rangée (70), comprenant une deuxième borne d'entrée (71), une deuxième borne de sortie (72) et une première borne de commande (73), la deuxième borne d'entrée étant connectée à la première borne de sortie et configurée pour recevoir l'instruction de mise à jour de compteur ; la première borne de commande étant configurée pour recevoir une instruction de commande de suivi de martèlement par rangée, le circuit de commande de suivi de martèlement par rangée étant configuré pour arrêter l'émission de l'instruction de mise à jour de compteur à la deuxième borne de sortie lorsque l'instruction de commande de suivi de martèlement par rangée est dans un état de premier niveau ;
dans lequel l'état de premier niveau de l'instruction de commande de suivi de martèlement par rangée sert à indiquer un état d'être en mode de test MBIST ; **caractérisé en ce que**
l'instruction externe est une instruction de précharge externe ; l'instruction de mise à jour de compteur sert à mettre à jour une unité de compteur de rangées (81) de la ligne de mots cible ; l'unité de compteur de rangées (81) de la ligne de mots cible connectée à la deuxième borne de sortie arrête la mise à jour lorsqu'aucune instruction de mise à jour de compteur n'est reçue ; et l'unité de compteur de rangées (81) est une cellule de mémoire configurée pour stocker un compte d'instructions actives d'une rangée cible.

2. Circuit de commande d'auto-test intégré de mémoire selon la revendication 1, dans lequel le circuit de commande de suivi de martèlement par rangée est configuré en particulier pour : faire passer l'instruction de mise à jour de compteur à un état de niveau cible lorsque l'instruction de commande de suivi de martèlement par rangée est dans l'état de premier niveau, l'unité de compteur de rangées ne répondant pas à l'état de niveau cible.

3. Circuit de commande d'auto-test intégré de mémoire selon la revendication 1 ou 2, dans lequel le circuit de commande de suivi de martèlement par rangée comprend : une unité de commutation (74), comprenant une première borne de connexion (741), une deuxième borne de connexion (742) et une borne de commande de commutation (743), dans lequel la première borne de connexion sert de deuxième borne d'entrée, la deuxième borne de connexion sert de deuxième borne de sortie, la borne de commande de commutation sert de première borne de commande, et la borne de commande de commutation est configurée pour : commander la première borne de connexion et la deuxième borne de connexion à être déconnectées lorsqu'un premier niveau est appliqué, et commander la première borne de connexion et la deuxième borne de connexion à être connectées lorsqu'un deuxième niveau est appliqué.

4. Circuit de commande d'auto-test intégré de mémoire selon la revendication 1 ou 2, dans lequel le circuit de commande de suivi de martèlement par rangée comprend : une unité de porte ET (AND1), comprenant une troisième borne d'entrée logique (X1), une quatrième borne d'entrée logique (X2) et une deuxième borne de sortie logique (Y1), dans lequel la troisième borne d'entrée logique sert de deuxième borne d'entrée, la deuxième borne de sortie logique sert de deuxième borne de sortie, et la deuxième borne de sortie logique sert de première borne de commande.

5. Circuit de commande d'auto-test intégré de mémoire selon l'une quelconque des revendications 1 à 4, dans lequel le circuit de commande de suivi de martèlement par rangée est en outre configuré pour : émettre l'instruction de mise à jour de compteur à la deuxième borne de sortie lorsque l'instruction de commande de suivi de martèlement par rangée est dans un état de deuxième niveau, de sorte que l'unité de compteur de rangées mette à jour un comptage d'instructions actives de la ligne de mots cible sur la base de l'instruction de mise à jour de compteur ; et l'un des états de premier niveau et de deuxième niveau est un état de haut niveau, et l'autre des états de premier niveau et de deuxième niveau est un état de bas niveau.

6. Circuit de commande d'auto-test intégré de mémoire selon l'une quelconque des revendications 1 à 5, dans lequel le circuit comprend en outre : un circuit de traitement de signaux (90), comprenant une troisième borne d'entrée (91), une quatrième borne d'entrée (92) et une troisième borne de sortie (93), dans lequel la troisième borne d'entrée est configurée pour recevoir une première instruction de précharge pour la ligne de mots cible envoyée par un hôte de commande (20) ; la quatrième borne d'entrée est configurée pour recevoir une deuxième instruction de précharge pour la ligne de mots cible envoyée par un système de test MBIST ; le circuit de traitement de signaux est configuré pour générer l'instruction de précharge externe lorsque la première instruction de précharge et/ou la deuxième instruction de précharge est/sont reçue(s) ; et la troisième borne de sortie est configurée pour émettre l'instruction de précharge externe.

7. Circuit de commande d'auto-test intégré de mémoire selon la revendication 6, dans lequel le circuit de traitement de signaux comprend : un sélecteur de données (M1), comprenant une deuxième borne de commande (C1), une première borne d'entrée de données (X3), une deuxième borne d'entrée de données (X4) et une borne de sortie de données (Y2), dans lequel la deuxième borne de commande est configurée pour recevoir un signal d'activation MBIST, la première borne d'entrée de données sert de troisième borne d'entrée du circuit de traitement de signaux, la deuxième borne d'entrée de données sert de quatrième borne d'entrée du circuit de traitement de signaux, la borne de sortie de données sert de troisième borne de sortie du circuit de traitement de signaux, et la borne de sortie de données est configurée pour : émettre la première instruction de précharge reçue depuis la première borne d'entrée de données comme instruction de précharge externe lorsque le signal d'activation MBIST est dans un état de troisième niveau, et émettre la deuxième instruction de précharge reçue depuis la deuxième borne d'entrée de données comme instruction de précharge externe lorsque le signal d'activation MBIST est dans un état de quatrième niveau.

8. Circuit de commande d'auto-test intégré de mémoire selon la revendication 6, dans lequel le circuit de traitement de signaux comprend : une unité de porte OU (OR1), l'unité de porte OU comprenant une première borne d'entrée logique (X5), une deuxième borne d'entrée logique (X6) et une première borne de sortie logique (Y3) ; la première borne d'entrée logique sert de troisième borne d'entrée du circuit de traitement de signaux, et la première instruction de précharge correspond à un signal de haut niveau ; la deuxième borne d'entrée logique sert de quatrième borne d'entrée du circuit de traitement de signaux, et la deuxième instruction de précharge correspond à un signal de haut niveau ; la première borne de sortie logique sert de troisième borne de sortie du circuit de traitement de signaux ; et la première borne de sortie logique est configurée pour émettre un signal de haut niveau qui sert d'instruction de précharge externe lorsque la première borne d'entrée logique et/ou la deuxième borne d'entrée logique reçoivent/reçoit le signal de haut niveau.

9. Circuit de commande d'auto-test intégré de mémoire selon l'une quelconque des revendications 1 à 8, dans lequel l'instruction de commande de suivi de martèlement par rangée est un signal inversé du signal d'activation MBIST.

10. Circuit de commande d'auto-test intégré de mémoire selon l'une quelconque des revendications 1 à 9, dans lequel le circuit de commande de mémoire est en outre configuré pour : obtenir une séquence de bits stockée dans un registre de modes ; et générer l'instruction de commande de suivi de martèlement par rangée sur la base d'une valeur de bit d'un champ prédéfini de la séquence de bits.

11. Circuit de commande d'auto-test intégré de mémoire selon l'une quelconque des revendications 1 à 10, dans lequel le circuit de commande de mémoire comprend en outre : une cinquième borne de sortie (63), dans lequel le circuit de commande de mémoire est en outre configuré pour générer une instruction de précharge interne en réponse à l'instruction de précharge externe, et la cinquième borne de sortie est configurée pour émettre l'instruction de précharge interne, de sorte qu'une cellule de mémoire (82) située sur la ligne de mots cible effectue une opération de précharge en réponse à l'instruction de précharge interne.

12. Circuit de commande d'auto-test intégré de mémoire selon l'une quelconque des revendications 1 à 11, dans lequel l'unité de compteur de rangées est en outre configurée pour : envoyer un signal de rétroaction à l'hôte de commande lorsque le comptage d'instruction actives est supérieur ou égal à un seuil de quantité prédéfini, de sorte que l'hôte de commande envoie, en réponse au signal de rétroaction, une instruction RFM à une mémoire à laquelle appartient la ligne de mots cible.

13. Circuit de commande d'auto-test intégré de mémoire selon l'une quelconque des revendications 1 à 12, dans lequel le circuit de commande MBIST correspond à au moins une matrice de mémoires (11) de la mémoire ; et les lignes de mots du ou des matrices de mémoires servent par séquence des lignes de mots cible.

14. Procédé de commande MBIST, comprenant : recevoir, par un circuit de commande de mémoire (60), une instruction de précharge externe d'une ligne de mots cible ; générer, par le circuit de commande de mémoire, une instruction de mise à jour de compteur en réponse à l'instruction de précharge externe, l'instruction de mise à jour de compteur servant à mettre à jour une unité de compteur de rangées de la ligne de mots cible ; recevoir, par un circuit de commande de suivi de martèlement par rangée (70), l'instruction de mise à jour de compteur et recevoir une instruction de commande de suivi de martèlement par rangée ; et arrêter, par le circuit de commande de suivi de martèlement par rangée, l'émission de l'instruction de mise à jour de compteur à une deuxième borne de sortie du circuit de commande de suivi de martèlement par rangée lorsque l'instruction de commande de suivi de martèlement par rangée est dans un état de premier niveau, de sorte qu'une unité de compteur de rangées (81) de la ligne de mots cible connectée à la deuxième borne de sortie arrête la mise à jour lorsque l'instruction de mise à jour de compteur n'est pas reçue ; l'unité de compteur de rangées (81) étant une cellule mémoire configurée pour stocker un comptage d'instructions actives d'une rangée cible ; l'état de premier niveau de l'instruction de commande de suivi de martèlement par rangée servant à indiquer un état d'être en mode de test MBIST.

15. Mémoire, comprenant au moins une matrice de mémoires (11) et le circuit de commande MBIST selon l'une quelconque des revendications 1 à 13.
